# EUROPEAN PATENT APPLICATION

(11) **EP 1 791 168 A1**
(43) Date of publication of application: **30.05.2007**
(21) Application number: 05775172.9
(22) Date of filing: 29.08.2005
(51) Int. Cl.: H01L 21/027, G03F 1/08

(54) **REFLECTIVE MASK BLANK FOR EUV LITHOGRAPHY AND METHOD FOR PRODUCING SAME**

(30) Priority: 17.09.2004 JP 2004271596
(71) Applicant: Asahi Glass Company, Limited, Chiyoda-ku, Tokyo 100-8405 (JP)
(72) Inventor: TAKAKI, Satoru, , Kanagawa-ku, Yokohama-shi, Kanagawa 22 (JP); HAYASHI, Kazuyuki, , Kanagawa-ku, Yokohama-shi, Kanagawa 22 (JP)
(74) Representative: Müller-Boré & Partner Patentanwälte
(86) International application number: PCT/JP2005/015678
(87) International publication number: WO 2006/030627

(57) **Abstract**

A reflective-type mask blank for EUV lithography for reducing the EUV ray reflectance at the absorbing layer and a method for producing the mask blank are presented. A reflective-type mask blank for EUV lithography comprising a substrate and a reflective layer for reflecting EUV light and an absorbing layer for absorbing EUV light, which are formed on the substrate in this order, the reflective-type mask blank for EUV lithography being **characterized in that** the absorbing layer is a Cr layer of low EUV ray reflectance deposited by an ion beam sputtering method.

## Description

### TECHNICAL FIELD

The present invention relates to a reflective-type mask blank for EUV (extreme ultraviolet) lithography used for producing a semiconductor or the like and a method for producing the mask blank.

### BACKGROUND ART

In the semiconductor industry, a photolithography method using visible light or ultraviolet light has been employed as a technique for writing, on a Si substrate or the like, a fine pattern, which is required for writing an integrated circuit comprising such a fine pattern. However, the conventional exposure techniques using light exposure have been close to the limit while semiconductor devices have had finer patterns at an accelerated pace. In the case of light exposure, it is said that the resolution limit of a pattern is about 1/2 of exposure wavelength, and even if an F₂ laser (157 nm) is employed, it is estimated that the resolution limit is about 70 nm. From this point of view, EUV lithography which is an exposure technique using EUV light having a shorter wavelength than F₂ laser has been considered as being promising as an exposure technique for 70 nm or below. In this description, it should be noted that the EUV light means a ray having a wavelength in a soft X-ray region or a vacuum ultraviolet ray region, specifically, a ray having a wavelength of about 10 to 20 nm.

It is impossible to use EUV light in conventional dioptric systems as in photolithography using visible light or ultraviolet light since EUV light is apt to be absorbed by any substance and the refractive index is close to 1. For this reason, a catoptric system, i.e. a combination of a reflective photomask and a mirror is employed in EUV light lithography.

A mask blank is a laminated member for fabrication of a photomask, which has not been patterned yet. When a mask blank is used for a reflective photomask, the mask blank has a structure wherein a substrate made of glass or the like has a reflective layer for reflecting EUV light and an absorbing layer for absorbing EUV light formed thereon in this order. The reflective layer is normally a multilayered reflective film, which comprises layers of high refractive index and layers of low refractive index laminated alternately to increase the light reflectance when irradiating the layer surface with a ray, more specifically, when irradiating the layer surface with EUV light.

On the other hand, for the absorbing layer, a material having a high coefficient of absorption to EUV light, specifically, a layer of a material containing Cr or Ta as the major component is used, and such layer is generally deposited by a magnetron sputtering method (see Patent Documents 1 to 5).

However, a thick absorbing layer causes a problem when a pattern is printed on a semiconductor substrate by employing a reflective-type photomask. Namely, when the reflective-type photomask is used, exposure light is not irradiated from a vertical direction to the photomask, but is generally irradiated in a direction inclined several degrees, e.g. about 2 to 10° from a vertical direction. Therefore, when the thickness of the mask pattern formed by dry-etching an absorbing layer is large, the shadow of the mask pattern is produced to thereby adversely affect the profile accuracy and the dimensional accuracy, and the pattern image reflected during the exposure of light loses its sharpness whereby the dimensional accuracy of the pattern is deteriorated.

In forming a reflective-type photomask from a mask blank, a predetermined pattern is formed by etching the absorbing layer. Depending on required fineness to the pattern, a dry-etching process such as reactive ion etching (RIE), plasma etching or the like is normally employed to form a pattern in a mask blank. In order to prevent the reflective layer from suffering damage in the dry-etching process, a protective layer is generally provided between the reflective layer and the absorbing layer to protect the reflective layer. The sum of the thickness of the protective layer and the thickness of the absorbing layer is equal to the thickness of the mask pattern. Accordingly, there is further limitation on the thickness of the absorbing layer.
Patent Document 1: JP-A-2002-319542
Patent Document 2: JP-A-2004-6798
Patent Document 3: JP-A-2004-6799
Patent Document 4: JP-A-2004-39884
Patent Document 5: JP-A-2002-222764

### DISCLOSURE OF THE INVENTION

### OBJECT TO BE ACCOMPLISHED BY THE INVENTION

The present invention is to provide a reflective-type mask blank for EUV photolithography to reduce the EUV ray reflectance of the absorbing layer and a method for producing the mask blank.

### MEANS TO ACCOMPLISH THE OBJECT

In order to achieve the above-mentioned object, the present invention is to provide a reflective-type mask blank for EUV lithography comprising a substrate and a reflective layer for reflecting EUV light and an absorbing layer for absorbing EUV light, which are formed on the substrate in this order, the reflective-type mask blank for EUV lithography being characterized in that the absorbing layer is a Cr layer deposited by an ion beam sputtering method. (Hereinbelow, referred to as "the mask blank of the present invention").

In the mask blank of the present invention, it is preferred that the reflectance of the reflective layer to the ray having the center wavelength of EUV light in the reflectance profile of the reflective layer in a case that a ray in the wavelength region of the EUV light is incident into the surface of the absorbing layer at an incident angle in a range of 2 to 10°, is 0.1% or less.

In the mask blank of the present invention, it is preferred that the thickness of the absorbing layer is 50 to 100 nm.

Further, in the mask blank of the present invention, it is preferred that between the reflective layer and the absorbing layer, a SiO₂ layer is formed as a protective layer by an ion beam sputtering method.

In the mask blank of the present invention, it is preferred that the contrast ratio (A/B) of an EUV ray reflectance A of the reflective layer to an EUV ray reflectance B of the absorbing layer is 600/1 or more, wherein the EUV ray reflectance A of the reflective layer is the reflectance of the reflective layer to the ray having the center wavelength of EUV light in the reflectance profile of the reflective layer in a case that a ray in the wavelength region of the EUV light is incident into the surface of the absorbing layer at an incident angle in a range of 2 to 10°, the reflectance A being measured after the formation of the reflective layer and the EUV ray reflectance B of the absorbing layer being measured after the formation of the absorbing layer.

Further, according to the present invention, there is provided a method for producing a reflective-type mask blank for EUV lithography comprising forming on a substrate a reflective layer for reflecting EUV light and an absorbing layer for absorbing EUV light in this order, the method being characterized in that a step of forming an absorbing layer by depositing a Cr layer by an ion beam sputtering method is included, and the reflectance of the reflective layer to the ray having the center wavelength of EUV light in the reflectance profile of the reflective layer in a case that a ray in the wavelength region of the EUV light is incident into the surface of the absorbing layer at an incident angle in a range of 2 to 10°, is 0.1% or less (hereinbelow, referred to as "the method for producing a mask blank of the present invention").

In the method for producing a mask blank of the present invention, it is preferred that before the step of forming the absorbing layer, a step of forming a protective layer by depositing on the reflective layer a SiO₂ layer by an ion beam sputtering method, is conducted.

### EFFECTS OF THE INVENTION

In the mask blank of the present invention, the absorbing layer is a Cr layer deposited by an ion beam sputtering method whereby the reflectance of EUV ray at the absorbing layer can be reduced. Preferably, the reflectance of EUV ray at the absorbing layer is 0.1% or less. By reducing the EUV ray reflectance at the absorbing layer, it is possible to provide an excellent contrast ratio of the EUV ray reflectance at the reflective layer to that at the absorbing layer, preferably, the contrast ratio of the EUV ray reflectance at the reflective layer to that at the absorbing layer is 600/1 or more. Thus, by conducting EUV lithography employing the reflective-type photomask having excellent contrast ratio, it is possible to form a pattern of high precision on a semiconductor substrate.

According to the method for producing a mask blank according to the present invention, the mask blank of the present invention wherein the EUV ray reflectance at the absorbing layer is 0.1% or less can be produced. Here, the EUV ray reflectance at the absorbing layer means the reflectance of the reflective layer to the ray having the center wavelength of EUV light in the reflectance profile of the reflective layer in a case that a ray in the wavelength region of the EUV light is incident into the surface of the absorbing layer at an incident angle in a range of 2 to 10°.

### BRIEF DESCRIPTION OF DRAWINGS

Fig. 1 is a cross-sectional view showing schematically a first embodiment of the mask blank of the present invention.
Fig. 2 is a graph showing a reflectance profile at the reflective layer.
Fig. 3 is a cross-sectional view showing schematically a first embodiment of the reflective-type photomask prepared by patterning the mask blank shown in Fig. 1.
Fig. 4 is a diagram for explaining a measuring process of the EUV ray reflectance at the absorbing layer in the mask blank shown in Fig. 1.
Figs. 5(a) and (b) are diagrams for explaining the measuring process of the contrast ratio of the EUV ray reflectance at the reflective layer and that at the absorbing layer wherein Fig. 5(a) is a diagram for explaining the measuring process of the EUV ray reflectance at the reflective layer and Fig. 5(b) is a diagram for explaining the measuring process of the EUV ray reflectance at the absorbing layer.

### MEANINGS OF SYMBOLS

- 1:: substrate
- 2:: reflective layer
- 3:: protective layer
- 4:: absorbing layer
- 6:: step
- 10:: mask blank
- 12:: photomask
- 20, 20a, 20b:: incident light
- 21, 21a, 21b:: reflected light

### BEST MODE FOR CARRYING OUT THE INVENTION

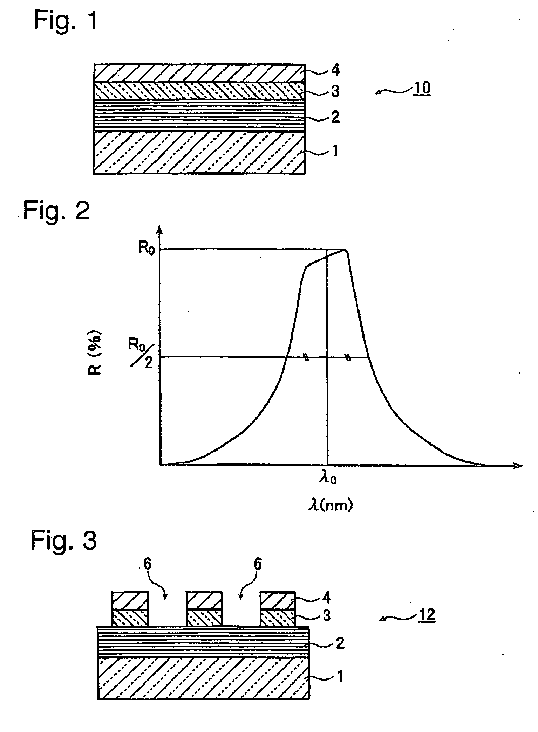

Fig. 1 is a cross-sectional view showing schematically a first embodiment of the mask blank of the present invention. In the mask blank 10 of the present invention shown in Fig. 1, a reflective layer 2 for reflecting EUV light and an absorbing layer 4 for absorbing EUV light are formed in this order on a substrate 1, and a protective layer 3 is provided between the reflective layer 2 and the absorbing layer 4. In the following, each constituent element of the mask blank 10 will be described.

It is preferred that the substrate 1 has a low coefficient of thermal expansion (preferably, 0±1.0×10⁻⁷/°C, more preferably, 0±0.3×10⁻⁷/°C) and that it is excellent in smoothness and flatness and has resistance to a cleaning liquid used for, e.g., cleaning a mask blank or a patterned photomask. Specifically, the substrate 1 is comprised of glass having a low coefficient of thermal expansion, such as SiO₂-TiO₂ glass. However, the substrate is not limited to such glass, but a substrate of crystallized glass with a β quartz solid solution precipitated therein, quartz glass, silicon, metal or the like may be employed.

It is preferred from the viewpoint of obtaining a high reflectance and printing precision in a photomask after pattern formation that the substrate 1 has a flat surface having a surface roughness Rms of 0.2 nm or less and a flatness of 100 nm or less.

Further, the substrate 1 has preferably a high rigidity in order to prevent the reflective layer 2, the protective layer 3 and the absorbing layer 4 formed thereon from deforming due to a membrane stress. Particularly, it is preferred that the substrate has a high Young's modulus of at least 65 GPa.

The dimensions, the thickness and the like of the substrate 1 are properly determined according to the design values of a photomask. In Example described later, a SiO₂-TiO₂ glass having outer dimensions of 6 inch (152.4 mm) square and a thickness of 0.25 inch (6.3 mm) was used.

The reflective layer 2 is preferably a layer having a high EUV ray reflectance. In this description, the ray reflectance means a reflectance obtained when a ray having a specified wavelength is irradiated to the surface of the reflective layer at an incident angle in a range of 2 to 10°. In this description, a ray having a specified wavelength means a ray in the wavelength region of EUV light, specifically, a ray in a wavelength of about 10 to about 20 nm. Further, an incident angle to the surface of the reflective layer means an angle of incident light when the direction perpendicular to the layer surface is 0°.

Further, in this description, the EUV ray reflectance means the reflectance of the reflective layer 2 to the ray having the center wavelength in the reflectance profile of the reflective layer when a ray in a wavelength region of EUV light is irradiated to the layer surface at an incident angle in a range of 2 to 10°.

The relation between a wavelength λ (nm) of reflected light and a reflectance R (%) at the reflective layer when a ray in a wavelength region of EUV light is irradiated to the surface of the reflective layer at an incident angle in a range of 2 to 10° is shown by a curve as shown in Fig. 2. This curve is referred to as the reflectance profile of the reflective layer. In Fig. 2, the highest reflectance in the curve is referred to as the peak reflectance R₀ (%). This curve has two points at positions corresponding to reflectance R₀/2. When these two points are connected with a linear line, the wavelength at the midpoint between the wavelengths corresponding to these two points is referred to as the center wavelength λ₀. In this description, the EUV ray reflectance means the reflectance to a ray at or near the center wavelength λ₀ in the reflectance profile of the reflective layer. The generally usable center wavelength λ₀ is 13.5 nm.

In the mask blank of the present invention, the maximum value of the EUV ray reflectance at the reflective layer 2 is preferably 60% or more, more preferably, 65% or more.

The measuring process of the EUV ray reflectance will be described later.

The reflective layer 2 should have a high EUV ray reflectance. Usually, a multilayered reflective film formed by laminating alternately a layer of high refractive index and a layer of low refractive index more than once, is employed as the reflective layer 2. In the multilayered reflective film, Mo is widely employed for the layer of high refractive index and Si is widely employed for the layer of low refractive index. Namely, a Mo/Si reflective film is most common. However, the multilayered reflective film is not limited thereto, but a Ru/Si reflective film, a Mo/Be reflective film, a Mo compound/Si compound reflective film, a Si/Nb reflective film, a Si/Mo/Ru reflective film, a Si/Mo/Ru/Mo reflective film and a Si/Ru/Mo/Ru reflective film may be employed. The film thickness of each layer constituting the multilayered reflective film and the number of the repeating unit of the layers are properly determined depending on materials of the films used and the EUV ray reflectance required for the reflective layer. Taking the Mo/Si reflective film for example, in order to form a reflective layer 2 wherein the maximum value of the EUV ray reflectance is at least 60%, a Mo layer having a film thickness of 2.3±0.1 nm and a Si layer having a film thickness of 4.5±0.1 nm should be laminated so as to have a repeating unit of 30 to 60. Each of the layers is formed to have a desired thickness by using a known film deposition method such as a magnetron sputtering method, an ion beam sputtering method or the like.

The protective layer 3 is formed to protect the reflective layer 2 so as not to suffer damage by an etching treatment when a pattern is formed in the absorbing layer 4 by an etching process, normally, by a dry-etching process. Accordingly, as material for the protective layer 3, it is preferred to employ a material less influenced by the etching treatment to the absorbing layer 4, namely, a material that the rate of etching is lower than that for the absorbing layer 4 and damage by the etching treatment is unlikely to take place, and that it can be removed by etching conducted later on. The material satisfying these conditions may be, for example, Cr, Al, Ru, Ta, a nitride thereof, SiO₂, Si₃N₄ or Al₂O₃. The protective layer 3 can be deposited by a known film deposition method such as a magnetron sputtering method, an ion beam sputtering method or the like in the same manner as the case of the reflective layer 2. However, the protective layer 3 is preferably a SiO₂ layer formed by the ion beam sputtering method because a film having a dense, smooth surface can be obtained. When the SiO₂ layer is formed as the protective layer 3 by the ion beam sputtering method, it is possible to reduce the EUV ray reflectance at the absorbing layer 4 formed on the protective layer 3.

In the mask blank of the present invention, the protective layer 3 is not an essential constituent. If it is possible to avoid any damage to the reflective layer 2 by the etching treatment by selecting an etching process or conditions thereof, the reflective layer 2 and the absorbing layer 4 can directly be laminated without the protective layer 3.

On the other hand, in the mask blank 10 shown in Fig. 1, a capping layer may be formed between the reflective layer 2 and the protective layer 3. It is rather preferred to form the capping layer. The capping layer is effective to prevent the surface of the reflective layer 2 from being oxidized. Specifically, the capping layer may be a Si layer. The capping layer can be formed by a known film deposition method such as a magnetron sputtering method, an ion beam sputtering method or the like in the same manner as the cases of the reflective layer 2 and the protective layer 3.

Accordingly, when the reflective layer 2 is a Mo/Si film, the top layer should be a Si layer whereby the capping layer can be provided. The film thickness of the capping layer is preferably 11.0±2 nm. When the film thickness of the capping layer is 11.0±2 nm, oxidation to the surface of the reflective layer 2 can effectively be prevented.

Fig. 3 is a cross-sectional view showing schematically a reflective-type photomask obtained by patterning the mask blank 10 shown in Fig. 1. In the photomask 12 shown in Fig. 3, when the protective layer 3 and the absorbing layer 4 are removed by an etching process, a step 6 is formed to provide a mask pattern. In conducting EUV lithography, EUV light is not incident into the mask surface from a vertical direction, but the light is normally incident with an angle of several degrees, specifically, an angle of 2 to 10° with respect to the vertical direction. When the step 6 in the mask pattern is large, the problem that the mask pattern does not have a sharp edge because of the light path of EUV light, is created. Therefore, the thickness of the protective layer 3 should be small. Further, after forming the pattern, the protective layer 3 is removed by etching. In this case, the thickness of the protective layer 3 be preferably smaller because the time required for the etching treatment can be shortened. Accordingly, the film thickness of the protective layer 3 is preferably from 10 to 60 nm, more preferably, from 10 to 45 nm.

In the mask blank 10 of the present invention, the absorbing layer 4 formed on the reflective layer 2 (or the protective layer 3) is a Cr layer deposited by an ion beam sputtering method.

The inventors of this application have found that when the absorbing layer 4 is a Cr layer deposited by the ion beam sputtering method, the EUV ray reflectance at the absorbing layer 4 can be reduced. By reducing the EUV ray reflectance at the absorbing layer 4, the contrast ratio of the EUV ray reflectance can be improved to increase the dimensional accuracy of a pattern to be formed. The contrast ratio of the EUV ray reflectance will be described later.

It is considered that the EUV ray reflectance at the absorbing layer decreases, depending on its thickness, with a periodical amplitude by the effect of interference by light reflected at the surface of the absorbing layer 4 and light reflected at the interface of the absorbing layer 4 and the reflective layer 3, and it can theoretically be reduced to 0.1% or less.

The optical characteristics of the absorbing layer deposited by a conventional magnetron sputtering method could not have an ideal optical constant. Accordingly, the EUV ray reflectance at the absorbing layer could not be reduced to a theoretical value, and it indicated at most about 0.2%.

On the other hand, in the mask blank 10 of the present invention, the EUV ray reflectance at the absorbing layer 4 can be reduced by forming a Cr layer, as the absorbing layer 4, deposited by an ion beam sputtering method, and the EUV ray reflectance at the absorbing layer 4 is preferably 0.1% or less, more preferably, 0.08% or less.

In the mask blank 10 of the present invention, the reason that the EUV ray reflectance at the absorbing layer 4 indicates 0.1% or less is not clear, however, it is estimated that a more dense, smooth film having an ideal optical constant can be formed by forming the Cr layer by the ion beam sputtering method.

The Cr layer of the present invention is a layer containing Cr as the major component wherein it contains at least 50 atomic% of Cr, preferably, at least 80 atomic%, more preferably, at least 95 atomic% of Cr. The Cr layer may contain an additive element A other than Cr. The presence of the additive element A is preferred because the film becomes amorphous and the surface can be made smooth.

The additive element A is preferably an element capable of absorbing light in a short wavelength region such as EUV (having a large extinction coefficient), and is preferably at least one member selected from the group consisting of Ag, Ni, In, Sn, Co, Cu, Pt, Zn, Au, Fe, Pd, Ir, Ta, Ga, Re, Pd, Ir, Ta, Ga, Re, W, Hf, Rh and Al. Particularly, as an element having the same extinction coefficient as or a larger extinction coefficient than Cr and having ability of absorbing light of shorter wavelength region such as EUV light, at least one member selected from the group consisting of Pd, Ir, Ta, Ga, Re, Cu, Pt, Zn, Au, Fe, Ag, Ni, In, Sn and Co is preferred. Further, it is preferred to be at least one member selected from the group consisting of Cu, Pt, Zn, Au, Fe, Ag, Ni, In, Sn and Co. Particularly, it is preferred to be at least one member selected from the group consisting of Ag, Ni, In, Sn and Co. The percentage of the additive element A is preferably from 10 to 35 atomic% based on the all elements in the Cr layer. In particular, it is preferred to employ an element having an extinction coefficient of at least 3×10⁻², more preferably, at least 5×10⁻² in a thickness of 13.5 nm.

The Cr layer of the present invention may further contain an additive element B other than the additive element A. The presence of the additive element B is preferred because the film becomes amorphous and the surface can be smooth. The additive element B is preferably at least one member selected from the group consisting of B, C, N, O, F, Si, P and Sb. Among these, it is preferred to be at least one member selected from the group consisting of B, Si and N.

In the present invention, the EUV ray reflectance can be obtained by a ratio of the luminous intensity of reflected light 21 measured with a spectrophotometer under the condition that a ray (incident light 20) having the center wavelength in the wavelength region of EUV light is irradiated onto the surface of the absorbing layer 4 at an incident angle θ to the luminous intensity of the incident light 20 with the same spectrophotometer. Here, the ray having the center wavelength in the wavelength region of EUV light may be light emitted from a synchrotron or light of laser plasma using a Xe-gas jet.

As described above, since the absorbing layer 4 and the protective layer 3 are etched to form the step 6 of a mask pattern, it is preferable for the thickness of the absorbing layer 4 to be small as far as a preferred low EUV ray reflectance can be obtained. The thickness of the absorbing layer 4 is preferably from 50 to 100 nm, more preferably, from 60 to 80 nm.

The thickness of the absorbing layer 4 having the above-mentioned range is also advantageous from the viewpoint that time for the etching treatment can be shortened.

In the mask blank 10 of the present invention, since the EUV ray reflectance at the absorbing layer 4 is 0.1% or less, an excellent contrast ratio of the EUV ray reflectance at the reflective layer 2 to that at the absorbing layer 4 can be obtained. The contrast ratio of the EUV ray reflectance is the ratio of an EUV ray reflectance at the reflective layer 2 to an EUV ray reflectance at the absorbing layer 4, and is expressed by the ratio A/B of an EUV ray reflectance A at the reflective layer 2, obtained by measuring after the reflective layer 2 has been formed but before the absorbing layer 4 is formed, to an EUV ray reflectance at the absorbing layer 4, measured after the absorbing layer 4 has been formed.

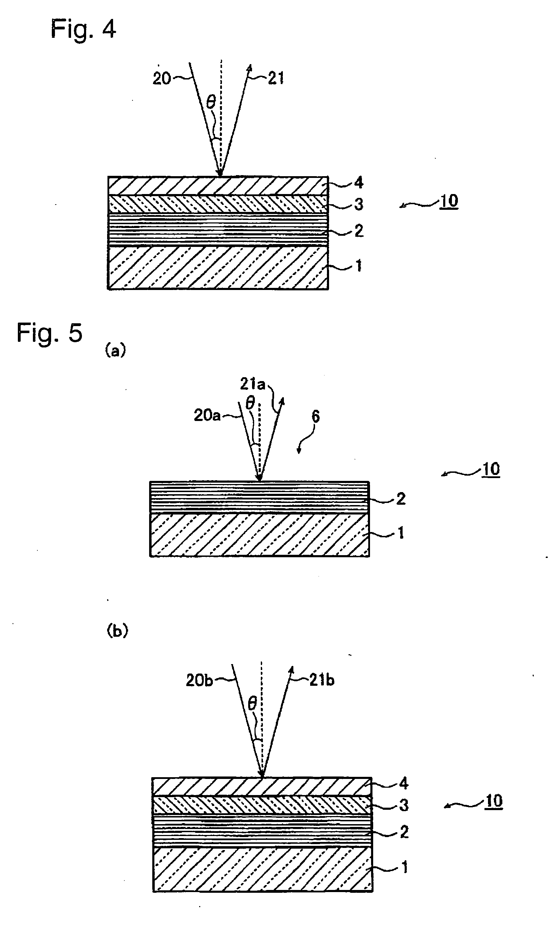

The EUV ray reflectance A at the reflective layer 2 is obtained from the ratio of a luminous intensity of reflected light 21a, measured with a spectrophotometer, at the reflective layer 2 before the protective layer 3 and the absorbing layer 4 are formed, when a ray (incident light) 20a having the center wavelength in the wavelength region of EUV light is irradiated to the surface of the reflective layer 2 at an incident angle θ, to a luminous intensity of the incident light 20a measured with the same spectrophotometer, as shown in Fig. 5 (a).

On the other hand, the EUV ray reflectance B at the absorbing layer 4 is obtained from the ratio of a luminous intensity of reflected light 21b at the absorbing layer 4, measured with the spectrophotometer, when a ray (incident light) 20b having the center wavelength in the wavelength region of EUV light is irradiated to the surface of the absorbing layer 4 at an incident angle θ, to a luminous intensity of the incident light 20b measured with the same spectrophotometer, as shown in Fig. 5(b).

In the mask blank 10 of the present invention, it is preferred that the contrast ratio (A/B) of the EUV ray reflectances A and B at the reflective layer 2 and the absorbing layer 4 is 600/1 or more, more preferably, 650/1 or more. When the contrast ratio has the above-mentioned range, it is possible to form a pattern of high precision on a semiconductor substrate when the substrate undergoes EUV lithography using this mask blank 10.

The method for producing the mask blank 10 of the present invention is the same as the conventional method except for the processes for forming the protective layer 3 and the absorbing layer 4.

In the method for producing the mask blank 10 of the present invention, the surface of a previously prepared substrate 1 is polished with abrasive grain such as cerium oxide, zirconium oxide, colloidal silica or the like, and then, the substrate surface is washed with an acid solution such as hydrofluoric acid, silicofluoric acid, sulfuric acid, or the like, an alkali solution such as sodium hydroxide, potassium hydroxide or the like or purified water.

Then, a reflective layer 2 is formed on the substrate 1. As the reflective layer 2, a multilayered reflective film formed by laminating a layer of high refractive index and a layer of low reflective index more than once is normally employed. The multilayered reflective film may be a Mo/Si reflective film, a Ru/Si reflective film, a Mo/Be reflective film, a Mo compound/Si compound reflective film, a Si/Nb reflective film, a Si/Mo/ Ru reflective film, a Si/Mo/Ru/Mo reflective film, a Si/Ru/Mo/Ru reflective film or the like. Each layer constituting such reflective film is formed by using a common deposition method such as an ion beam sputtering method, a magnetron sputtering method or the like. However, the ion beam sputtering method is preferably employed because a dense film having a smooth surface is obtainable. When the Mo/Si reflective film is deposited by the ion beam sputtering method, it is preferred that a Si film is deposited so as to have a thickness of 4.5±0.1 nm, using a Si target (boron-doped) as the target, using an Ar gas (having a gas pressure of 1.3×10⁻² Pa to 2.7×10⁻² Pa) as the sputtering gas, applying a voltage of 400 to 800 V and setting the film deposition rate at a value of 0.05 to 0.09 nm/sec and then a Mo film is deposited so as to have a thickness of 2.3±0.1 nm, using a Mo target as the target, using an Ar gas (having a gas pressure of 1.3×10⁻² Pa to 2.7×10⁻² Pa) as the sputtering gas, applying a voltage of 400 to 800 V and setting the film deposition rate at a value of 0.5 to 0.09 nm/sec. Taking this process as one cycle, the lamination of the Si film and the Mo film is conducted in cycles of from 30 to 60 to thereby form a multilayered reflective film (Mo/Si reflective film). When the film deposition rate is determined to be the above-mentioned range, dense Si and Mo films can be obtained. In this case, when the top layer is comprised of a Si film, a capping layer can be provided between the reflective layer 2 and the protective layer 3.

Then, on the surface of the reflective layer 2, the protective layer 3 is deposited by using a known deposition method such as a magnetron sputtering method, an ion beam sputtering method or the like, the protective layer being a layer comprising Cr, Al, Ru, Ta, a nitride thereof, SiO₂, Si₃N₄ or Al₂O₃ for example. However, it is preferred to deposit the SiO₂ film by the ion beam sputtering method because a dense film having a smooth surface can be obtained. When the ion beam sputtering method is employed to form the SiO₂ film, it is preferred to form it to have a thickness of 10 to 60 nm using a Si target (boron-doped) as the target, using Ar gas and O₂ gas (a gas pressure of 2.7×10⁻² Pa to 4.0×10⁻² Pa), applying a voltage of 1,200 to 1,500 V and setting the film deposition rate at a value of 0.01 to 0.03 nm/sec. At a film deposition rate of 0.01 to 0.03 nm/sec, a film having resistance to an etching treatment can be obtained.

Then, on the surface of the protective layer 3, a Cr film is deposited as the absorbing layer 4 by an ion beam sputtering method. In this case, it is preferred to deposit the film to have a thickness of 50 to 100 nm using a Cr target as the target, using an Ar gas (a gas pressure of 1.3×10⁻² Pa to 4.0×10⁻² Pa) as the sputtering gas, applying a voltage of 400 to 800 V and setting the film deposition rate at a value of 0.06 to 0.9 nm/sec. The film deposition rate in a range of 0.06 to 0.09 nm/sec is effective to obtain a smooth absorbing layer 4 having an ideal optical constant. When a Cr layer containing an additive element A and/or an additive element B is formed, it can be formed by causing simultaneous discharges using different targets, or using a target comprising mixed elements, or introducing a reactive gas comprising these elements.

Thus, the mask blank 10 of the present invention can be produced by the above-mentioned processes.

In the following, the process for producing a reflective-type photomask for EUV lithography by patterning the mask blank 10 of the present invention.

In patterning the mask blank 10 of the present invention, an electron-beam printing technique is generally employed in order to form a fine pattern.

In order to form a pattern by employing the electron-beam printing technique, first, a resist for electron-beam printing is applied to the surface of the absorbing layer 4 of the mask blank 10, and then, a baking treatment is conducted at 200°C, for example. Then, electron beams are irradiated to the surface of the resist with an electron-beam printing device, followed by developing, whereby a resist pattern is formed.

Then, using this resist pattern as a mask, the absorbing layer 4 of the mask blank 10 is etched to thereby form a pattern in the absorbing layer 4. When an etching process is conducted, a dry etching process are generally employed because a fine pattern can be formed. There is in particular no limitation as to types of dry etching process but a known method, specifically, gas phase etching, plasma etching, reactive ion etching (RIE), sputter-etching, ion beam etching or photoetching can be employed. However, RIE is generally employed because a fine pattern can be formed and there are many materials applicable to etching. When RIE is employed, a fluorine or chlorine type gas is used as an etchant gas and dry etching is conducted at a substrate temperature of 20°C, for example, whereby a pattern is formed in the absorbing layer 4. Subsequently, the protection layer 3 is subjected to dry etching or wet etching. By removing the resist remaining on the pattern, a reflective-type photomask for EUV lithography having a desired pattern can be obtained.

### EXAMPLES

In the following, the present invention will be described with Examples.

### EXAMPLE

In this Example, the mask blank shown in Fig. 1 was prepared by the following process.

### FORMATION OF REFLECTIVE LAYER

In this Example, a SiO₂-TiO₂ type glass substrate 1 (having outer dimensions of 6 inch (152.4 mm) square and a thickness of 6.3 mm) was used. This glass substrate 1 has a thermal expansion coefficient of 0.2×10⁻⁷/°C and a Young's modulus of 67 GPa. The glass substrate 1 was polished so that the surface having a surface roughness Rms of 0.2 nm or less and a flatness of 100 nm or less was formed.

On the surface of the glass substrate 1, a Si film and a Mo film were deposited alternately in 40 cycles by an ion beam sputtering method, whereby a Mo/Si reflective film (reflective layer 2) having a total film thickness of 272 nm ((4.5+2.3)×40) was formed. Finally, a Si layer was deposited to have a film thickness of 11.0 nm as a capping layer.

Conditions of depositing the Si film and the Mo film were as follows.

### CONDITIONS OF DEPOSITING Si FILM

Target: Si target (boron-doped)
Sputtering gas: Ar gas (gas pressure: 0.02 Pa)
Voltage: 700 V
Film deposition rate: 0.077 nm/sec
Film thickness: 4.5 nm

### CONDITIONS OF DEPOSITING Mo FILM

Target: Mo target
Sputtering gas: Ar gas (gas pressure: 0.02 Pa)
Voltage: 700 V
Film deposition rate: 0.064 nm/sec
Film thickness: 2.3 nm

### FORMATION OF PROTECTIVE LAYER

On the surface of the reflective layer 2, a SiO₂ film was deposited as the protective layer 3 using an ion beam sputtering method. Conditions of depositing the SiO₂ film were as follows.

### CONDITIONS OF DEPOSITING SiO₂ FILM

Target: Si target (boron-doped)
Sputtering gas: Ar gas and O₂ gas (gas pressure: 3.3×10⁻² Pa, gas ratio: 50 vol%)
Voltage: 1,450 V
Film deposition rate: 0.023 nm/sec
Film thickness: 30 nm

### FORMATION OF ABSORBING LAYER

On the surface of the protective layer 3, a Cr film was deposited as the absorbing layer 4 using an ion beam sputtering method. Conditions of depositing the Cr film were as follows.

### CONDITIONS OF DEPOSITING Cr FILM

Target: Cr target
Sputtering gas: Ar gas (gas pressure: 3.3×10⁻² Pa)
Voltage: 700 V
Film deposition rate: 0.082 nm/sec
Film thickness: 70 nm

The mask blank 10 shown in Fig. 1 was obtained by the above-mentioned process. Dimensions of the obtained mask blank were as follows.
Outer dimensions: 6 inch (152.4 mm) square
Substrate: thickness of 6.3 mm
Reflective layer: thickness of 283 nm (including a capping layer)
Protective layer: thickness of 30 nm
Absorbing layer: thickness of 70 nm

### EUV REFLECTANCE AT ABSORBING LAYER

The EUV ray reflectance at the absorbing layer 4 of the obtained mask blank 10 was measured.

Specifically, a EUV ray 20 (light emitted from a synchrotron) was irradiated to the surface of the absorbing layer 4 at an incident angle θ (6°), as shown in Fig. 4.

The luminous intensity of the reflected light 21 produced thereby was measured with a spectrophotometer and the luminous intensity of the incident light 20 was also measured with the same spectrophotometer. Then, the EUV ray reflectance B at the absorbing layer 4 was obtained from the ratio of the both measured values.

As a result, the EUV ray reflectance B at the absorbing layer 4 was 0.08%. In the measurement of the EUV ray reflectance B, the reflectance profile as shown in Fig. 2 was prepared and, the center wavelength λ₀ was determined and this center wavelength λ₀ was employed. The EUV ray reflectance B is a reflectance to a ray having the center wavelength in the reflectance profile, and here, a ray having a wavelength of 13.5 nm was employed.

### CONTRAST RATIO OF EUV RAY REFLECTANCES AT REFLECTIVE LAYER AND ABSORBING LAYER

In the process of producing the above-mentioned mask blank, the EUV ray reflectance A at the reflective layer 2, after the formation of the reflective layer 2 but before the formation of the protective layer 3 and the absorbing layer 4, was obtained by the same procedure as the EUV ray reflectance B at the absorbing layer 4. As a result, the EUV ray reflectance A at the reflective layer 2 was 63%. The EUV ray reflectance A is the reflectance to a ray having the center wavelength in the reflectance profile, and here, a ray having a wavelength of 13.5 nm was employed.

Then, it was confirmed that the contrast ratio of the ray reflectances at the reflective layer 2 and the absorbing layer 4 was 63/0.08 (=787.5).

### COMPARATIVE EXAMPLE

### FORMATION OF REFLECTIVE LAYER

On a glass substrate 1 formed in the same manner as Example, a Mo/Si film (reflective layer 2) is formed by laminating alternately Si and Mo by a DC magnetron sputtering method. First, a Si film of 4.5 nm was deposited using a Si target under an Ar gas pressure of 0.1 Pa, and then, a Mo film of 2.3 nm was deposited using a Mo target under an Ar gas pressure of 0.1 Pa. Taking these film deposition process as one cycle, lamination of the films is conducted 40 cycles. The total film thickness is 272 nm. To the reflective layer 2, an EUV ray is irradiated at an incident angle of 6° to measure the EUV ray reflectance at the reflective layer 2 in the same manner as Example. The measured EUV ray reflectance is 62%. The EUV ray reflectance is the reflectance to the ray having the center wavelength in the reflectance profile, and here, the ray having a wavelength of 13.5 nm is employed.

### FORMATION OF PROTECTIVE LAYER

Then, a protective layer 3 is formed on the reflective layer 2 by depositing a SiO₂ layer by a DC magnetron sputtering method. The protective layer 3 is formed by depositing a SiO₂ layer to have a thickness of 30 nm using a Si target (boron-doped) and using gas, as sputtering gas, comprising an Ar gas and O₂ added in an amount of 90% in volume ratio.

### FORMATION OF ABSORBING LAYER

Further, an absorbing layer 4 is formed on the protective layer 3 by depositing a Cr layer by a DC magnetron sputtering method. The absorbing layer 4 is formed by depositing the Cr layer to have a thickness of 70 nm using a Cr target and using an Ar gas as sputtering gas, whereby a mask blank 10 is obtained.

### EUV RAY REFLECTANCE AT ABSORBING LAYER

On the obtained mask blank 10, the EUV reflectance at the absorbing layer 4 is measured in the same procedure as Example. The obtained EUV ray reflectance is at least 0.2%. The EUV ray reflectance is the reflectance to the ray having the center wavelength in the reflectance profile, and here, the ray having a wavelength of 13.5 nm is employed.

From the obtained value and the EUV ray reflectance at the reflective layer 2, the contrast ratio of EUV ray reflectances at the reflective layer 2 and the absorbing layer 4 is 62/0.2 (=310).

### INDUSTRIAL APPLICABILITY

In the mask blank of the present invention, the EUV ray reflectance at the absorbing layer can be reduced by forming the Cr layer, as the absorbing layer, deposited by an ion beam sputtering method. Accordingly, a reflective-type photomask excellent in the contrast ratio of EUV ray reflectances at the reflective layer and the absorbing layer can be obtained. By using such reflective-type photomask and conducting EUV lithography, a highly accurate pattern can be formed on a semiconductor substrate.

The entire disclosure of Japanese Patent Application No. 2004-271596 filed on September 17, 2004 including specification, claims, drawings and summary is incorporated herein by reference in its entirety.

## Claims

1. A reflective-type mask blank for EUV lithography comprising a substrate and a reflective layer for reflecting EUV light and an absorbing layer for absorbing EUV light, which are formed on the substrate in this order, the reflective-type mask blank for EUV lithography being **characterized in that** the absorbing layer is a Cr layer deposited by an ion beam sputtering method.

2. The reflective-type mask blank for EUV lithography according to Claim 1, wherein the reflectance of the reflective layer to the ray having the center wavelength of EUV light in the reflectance profile of the reflective layer in a case that a ray in the wavelength region of the EUV light is incident into the surface of the absorbing layer at an incident angle in a range of 2 to 10°, is 0.1% or less.

3. The reflective-type mask blank for EUV lithography according to Claim 1 or 2, wherein the thickness of the absorbing layer is 50 to 100 nm.

4. The reflective-type mask blank for EUV lithography according to any one of Claims 1 to 3, wherein the reflective layer is a multilayered reflective film formed by laminating alternately more than once a high refractive index layer and a low refractive index layer.

5. The reflective-type mask blank for EUV lithography according to any one of Claims 1 to 4, wherein between the reflective layer and the absorbing layer, a SiO₂ layer is formed as a protective layer by an ion beam sputtering method.

6. The reflective-type mask blank for EUV lithography according to Claim 5, wherein the thickness of the protective layer is 10 to 60 nm.

7. The reflective-type mask blank for EUV lithography according to Claim 5 or 6, wherein between the reflective layer and the protective layer, a Si layer is provided as a capping layer.

8. The reflective-type mask blank for EUV lithography according to Claim 7, wherein the thickness of the capping layer is 11.0±2 nm.

9. The reflective-type mask blank for EUV lithography according to any one of Claims 1 to 8, wherein the Cr layer includes at least 50 atomic% of Cr.

10. The reflective-type mask blank for EUV lithography according to Claim 9, wherein the Cr layer includes an additive element A other than Cr.

11. The reflective-type mask blank for EUV lithography according to Claim 10, wherein the additive element A is at least one member selected from the group consisting of Ag, Ni, In, Sn, Co, Cu, Pt, Zn, Au, Fe, Pd, Ir, Ta, Ga, Re, Pd, Ir, Ta, Ga, Re, W, Hf, Rh and Al.

12. The reflective-type mask blank for EUV lithography according to Claim 10 or 11, wherein the Cr layer further includes an additive element B.

13. The reflective-type mask blank for EUV lithography according to Claim 12, wherein the additive element B is at least one member selected from the group consisting of B, C, N, O, F, Si, P and Sb.

14. The reflective-type mask blank for EUV lithography according to any one of Claims 1 to 13, wherein the contrast ratio (A/B) of an EUV ray reflectance A of the reflective layer to an EUV ray reflectance B of the absorbing layer is 600/1 or more, wherein the EUV ray reflectance A of the reflective layer is the reflectance to the ray having the center wavelength of EUV light in the reflectance profile of the reflective layer in a case that a ray in the wavelength region of the EUV light is incident into the layer surface at an incident angle in a range of 2 to 10°, the reflectance A being measured after the formation of the reflective layer and the EUV ray reflectance B of the absorbing layer being measured after the formation of the absorbing layer.

15. A method for producing a reflective-type mask blank for EUV lithography comprising forming on a substrate a reflective layer for reflecting EUV light and an absorbing layer for absorbing EUV light in this order, the method being **characterized in that** a step of forming an absorbing layer by depositing a Cr layer by an ion beam sputtering method is included, and the reflectance to the ray having the center wavelength of EUV light in the reflectance profile of the reflective layer in a case that a ray in the wavelength region of the EUV light is incident into the surface of the absorbing layer at an incident angle in a range of 2 to 10°, is at 0.1% or less.

16. The method for producing a reflective-type mask blank for EUV lithography according to Claim 15, wherein before the step of forming the absorbing layer, a step of forming a protective layer by depositing on the reflective layer a SiO₂ layer by an ion beam sputtering method, is conducted.

17. The method for producing a reflective-type mask blank for EUV lithography according to Claim 15 or 16, wherein a Mo/Si reflecting film is formed as the reflective layer, a Si film is formed at a film deposition rate of 0.05 to 0.09 nm/sec and a Mo film is formed at a film deposition rate of 0.05 to 0.09 nm/sec.

18. The method for producing a reflective-type mask blank for EUV lithography according to Claim 16, wherein the protective layer is formed at a film deposition rate of 0.01 to 0.03 nm/sec.

19. The method for producing a reflective-type mask blank for EUV lithography according to any one of Claims 15 to 18, wherein the absorbing layer is formed at a film deposition rate of 0.06 to 0.09 nm/sec.
